# EUROPEAN PATENT SPECIFICATION

(11) **EP 2 734 471 B1**
(45) Date of publication and mention of the grant of the patent: **20.12.2017**
(21) Application number: 11749597.8
(22) Date of filing: 20.07.2011
(51) Int. Cl.: B01J 19/24

(54) **MANUFACTURING APPARATUS FOR DEPOSITING A MATERIAL ON A CARRIER BODY**
HERSTELLUNGSGERÄT ZUR ABSCHEIDUNG EINES MATERIALS AUF EINEM TRÄGERKÖRPER
DISPOSITIF DE FABRICATION POUR DÉPOSER UNE MATIÈRE SUR UN CORPS DE SUPPORT

(43) Date of publication of application: 28.05.2014
(73) Proprietor: Hemlock Semiconductor Operations LLC, Hemlock, MI 48626 (US)
(72) Inventor: ANDERSON, Michael, L., Midland, MI 48640 (US); TROMBLEY, Stephen, Midland, MI 48642 (US)
(74) Representative: Murgitroyd & Company
(86) International application number: PCT/US2011/044695
(87) International publication number: WO 2013/012422

(56) References cited:
- WO-A1-99/01403
- CN-A- 1 118 047
- US-A- 3 286 685
- US-A- 3 918 396
- US-B1- 6 399 204

## Description

### FIELD OF THE INVENTION

The present invention generally relates to a manufacturing apparatus for depositing a material on a carrier body. More specifically, the present invention relates to a gasket for use in the manufacturing apparatus.

### BACKGROUND OF THE INVENTION

Manufacturing apparatuses for depositing a material on a carrier body are known in the art. For example, silicon may be deposited on the carrier body to produce polycrystalline silicon. It is desirable to deposit the material with a high purity such that contamination of the material by impurities is limited. Depositing the material, especially silicon with high purity, involves careful control of environmental conditions surrounding the deposition process. For example, any substance that is in direct physical or atmospheric communication with the material can potentially contribute impurities to the material, thereby contaminating the material.

Under certain conditions, substances that are in direct physical or atmospheric communication with the material can contribute even greater amounts of impurities to the material. For example, when the substances are heated, many impurities present therein are subject to release from the substances. The released impurities that are released by the substances can then be introduced within the reaction chamber. Once the released impurities enter the reaction chamber, the released impurities can be absorbed by the material thereby contaminating the material. As such, any substance that is subject to heating in the presence of the material can have a significant effect on contamination to the material. In a conventional manufacturing apparatus, a gasket that is used to seal the reaction chamber is a potential point of contamination of the material.

Generally, during operation of the conventional manufacturing apparatus, the carrier body is heated in the presence of a deposition gas, which contains the material, to deposit the material on the carrier body. The heating of the carrier body results in the heating of the reaction chamber and consequently the heating of the gasket. Typically, the gasket comprises a Teflon® impregnated material that contains substances that would be considered impurities if found in the material. The heating of the gasket and the expose of the gasket to the deposition gas results in the release of impurities into the reaction chamber from the gasket.

The impurities released into the reaction chamber contaminate the material on the carrier body, which is undesirable. Additionally, as the gasket is heated, the gasket losses flexibility and suffers extensive creep relaxation, which prevents the gasket from properly sealing the reaction chamber. If the reaction chamber is not properly sealed, impurities from outside the reaction chamber may enter the reaction chamber and contaminate the material.

The conventional manufacturing apparatus may be equipped with cooling devices, such as a water-cooling jacket, in an effort to cool the gasket during operation of the conventional manufacturing apparatus. The cooling devices limit the heating of the gasket in an effort to prevent the release of impurities from the gasket and prevent hardening and creep relaxation of the gasket. However, there is movement in the industry away from the use of the cooling devices due to increased costs and maintenance associated with the use of the cooling devices. As such, there remains a need to provide an improved gasket for a manufacturing apparatus for depositing material on a carrier body.

### SUMMARY OF THE INVENTION AND ADVANTAGES

A gasket is used in a manufacturing apparatus that deposits a material on a carrier body. The gasket seals between a housing and a base plate of the manufacturing apparatus. A reaction chamber is defined by the housing and the base plate. The gasket prevents a deposition composition, which comprises the material to be deposited or a precursor thereof, from escaping the reaction chamber. The gasket comprises a flexible graphite material. The flexible graphite material prevents the gasket from contaminating the material within the reaction chamber. Therefore, the gasket can be used in manufacturing apparatuses that produce materials of a high purity. Additionally, the gasket can be used in manufacturing apparatuses that do not have a cooling device while still minimizing the contribution of impurities to the material, such that the manufacturing apparatuses can produce the material of a high purity.

### BRIEF DESCRIPTION OF THE DRAWINGS

Other advantages of the present invention will be readily appreciated, as the same becomes better understood by reference to the following detailed description when considered in connection with the accompanying drawings wherein:
Figure 1 is a partial cross-sectional view of a manufacturing apparatus for depositing a material on a carrier body with the manufacturing apparatus having a housing coupled to a base plate for defining a reaction chamber;
Figure 2 is a cross-sectional view of a portion of the manufacturing apparatus with a gasket disposed within a groove defined by the base plate between a finger extending from a flange of the housing and the base plate;
Figure 3 is a cross-sectional view of the portion of the manufacturing apparatus with the gasket disposed between the flange of the housing and the base plate and also between the reaction chamber and the groove of the base plate;
Figure 4 is a cross-sectional view of the portion of the manufacturing apparatus with the gasket disposed between the flange of the housing and the base plate and also between the groove of the base plate and a bolt, which couples the housing to the base plate;
Figure 5 is a cross-sectional view of the portion of the manufacturing apparatus with a first gasket disposed within the groove of the base plate between the finger and the base plate and a second gasket disposed between the flange of the housing and the base plate and also between the groove of the base plate and a bolt, which couples the housing to the base plate;
Figure 6A is a top view of a segment of the gasket;
Figure 6B is a top view of a plurality of the segments of Figure 6A with the segments overlapping to form the gasket;
Figure 7A is a top view of alternative segment of the gasket having a first end defining a recess and a second end having a leg extending there from;
Figure 7B is a top view of a plurality of the segments of Figure 7A with the segments interlocking to form the gasket;
Figure 8A is a top view of another alternative segment of the gasket having first and second ends each defining a notch; and
Figure 8B is a top view of a plurality of the segments of Figure 8A with the segments interlocking to form the gasket.

### DETAILED DESCRIPTION OF THE INVENTION

Referring to the Figures, wherein like numerals indicate like or corresponding parts throughout the several views, a manufacturing apparatus is generally shown at 10. During operation of the manufacturing apparatus 10, material is deposited on a carrier body 12. For example, the manufacturing apparatus 10 may be a chemical vapor deposition reactor, such as a Siemens type chemical vapor deposition reactor, for depositing silicon on the carrier body 12 to produce high purity polycrystalline silicon. The carrier body 12 may have a substantially U-shaped configuration. However, it is to be appreciated that the carrier body 12 may have configurations other than the U-shaped configuration. Additionally, when the material to be deposited is silicon, the carrier body 12 is typically a silicon slim rod comprising high purity silicon with the silicon deposited on the silicon slim rod for producing high purity polycrystalline silicon.

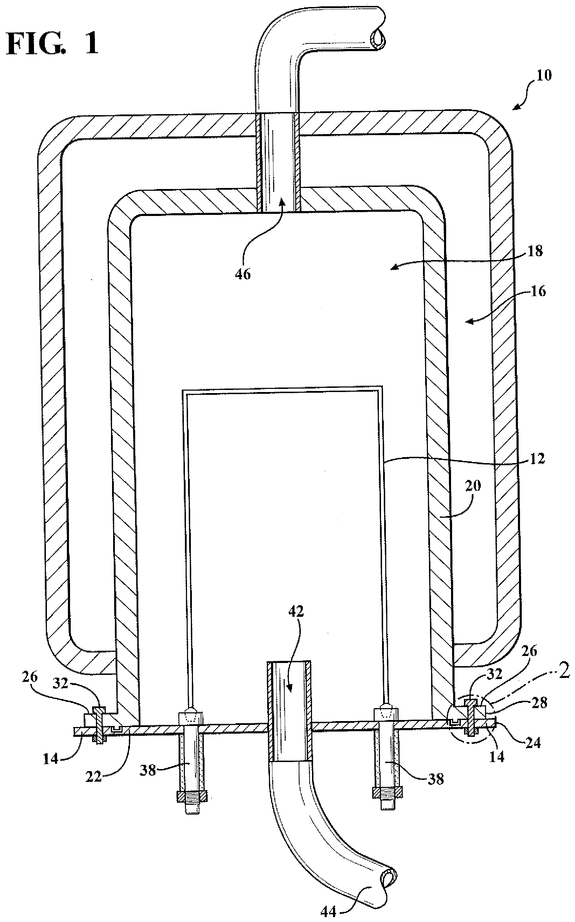

With reference to Figure 1, the manufacturing apparatus 10 comprises a base plate 14 and a housing 16 for coupling with the base plate 14 to define a reaction chamber 18. The housing 16 has at least one wall 20 with the wall 20 typically presenting a cylindrical configuration of the housing 16. However, it is to be appreciated that the housing 16 may have configurations other than cylindrical, such as a cubed configuration. The housing 16 has an end 22 that is open for allowing access to an interior of the housing 16. The base plate 14 is coupled to the end 22 of the housing 16 that is open for covering the end 22 to define the reaction chamber 18. Generally, the base plate 14 is transverse to the wall 20 of the housing 16 when the base plate 14 is coupled to the housing 16. Additionally, the base plate 14 typically extends beyond the wall 20 of the housing 16 to a base plate end 24.

With reference to Figures 1-5, the housing 16 has a flange 26, which extends from the wall 20 of the housing 16. More specifically, the flange 26 extends transversely from the wall 20 of the housing 16 to a flange end 28. When the base plate 14 is coupled to the housing 16, the base plate end 24 and the flange end 28 are typically aligned with one another with the flange 26 parallel to the base plate 14. Typically, the flange 26 is parallel with the base plate 14 when the base plate 14 is coupled to the housing 16. The flange 26 allows the base plate 14 to be coupled to the housing 16. Typically, both the flange 26 and the base plate 14 define a hole 30 for receiving a fastener 32, such as a bolt, to secure the housing 16 to the base plate 14. Said differently, the fastener 32 prevents the housing 16 and the base plate 14 from moving relative to each other. It is to be appreciated that the hole 30 in the base plate 14 and the flange 26 may be threaded for receiving threads of the fastener 32.

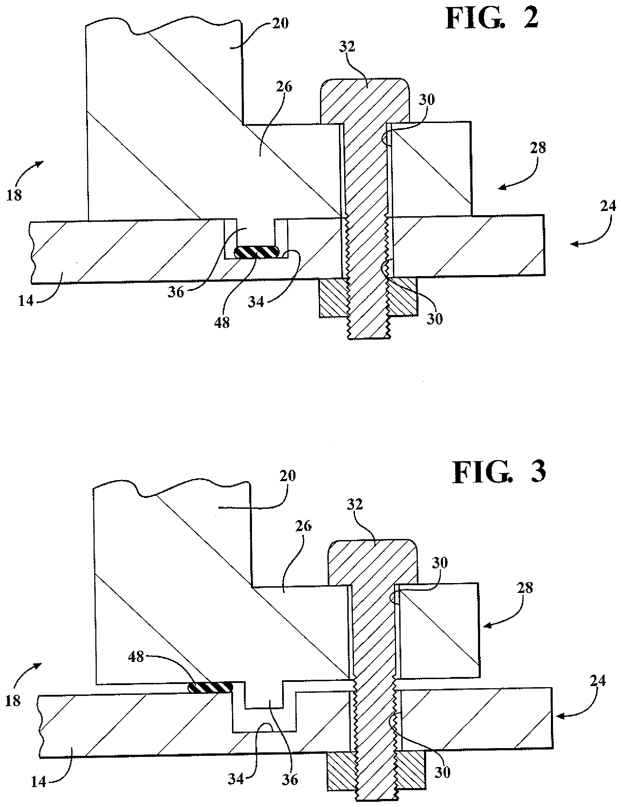

As best illustrated in Figures 2-5, the base plate 14 may define a groove 34. The groove 34 is defined about a periphery of the base plate 14. Additionally, the flange 26 of the housing 16 may have a finger 36 extending from the flange 26 for engaging the groove 34 of the base plate 14. The engagement of the finger 36 of the flange 26 with the groove 34 of the base plate 14 ensures that the base plate 14 and the housing 16 are properly aligned when coupling the housing 16 to the base plate 14.

The manufacturing apparatus 10 includes an electrode 38 at least partially disposed within the reaction chamber 18. The electrode 38 is typically disposed through the base plate 14. The carrier body 12 is coupled to the electrode 38 within the reaction chamber 18. Typically, the electrode 38 comprises an electrically conductive material having a minimum electrical conductivity at room temperature of at least 14×10⁶ Siemens/meter or S/m. For example, the electrode 38 can comprise at least one of copper, silver, nickel, Inconel and gold, each of which meets the conductivity parameters set forth above. Additionally, the electrode 38 can comprise an alloy that meets the conductivity parameters set forth above. More typically, the electrically conductive material of the electrode 38 has a minimum electrical conductivity at room temperature of about 58×10⁶ S/m. The electrode 38 typically comprises copper with the copper present in an amount of about 100% by weight based on the weight of the electrode 38. The copper can be oxygen-free electrolytic copper grade UNS 10100.

The electrode 38 is heated within the reaction chamber 18 by passage of an electric current through the electrode 3⁸. As a result of the heating of the electrode 38, the carrier body 12 is heated to a deposition temperature through a process known as Joule heating. Typically, the deposition temperature of the carrier body 12 within the reaction chamber 18 is of from about 800 to about 1,250, more typically of from about 900 to about 1,150, and even more typically of from about 950 to about 1,100 degrees centigrade. The Joule heating of the carrier body 12 results in a radiant/convective heating of the reaction chamber 18 and other material in communication with the carrier body 12. Typically, during operation of the manufacturing apparatus 10, an operating temperature of the reaction chamber 18 is of from about room temperature to about 400, more typically of from about 150 to about 350, and even more typically of from about 150 to about 350 degrees centigrade. It is to be appreciated that the operation temperature is not constant during operation of the manufacturing apparatus 10 and the operating temperature generally increases during operation.

The radiant/convective heating of the reaction chamber 18 generally facilitates thermal decomposition of a deposition composition. The deposition composition comprises the material to be deposited on the carrier body 12 or a precursor thereof. For example, the material to be deposited may be silicon and the deposition composition may comprise a halosilane, such as a chlorosilane or a bromosilane. The deposition composition may further comprise hydrogen. However, it is to be appreciated that the deposition composition may comprise other precursors, especially silicon containing molecules such as silane, silicon tetrachloride, tribromosilane, and trichlorosilane. Typically, when the material to be deposited is silicon, the carrier body 12 is the silicon slim rod and the deposition composition contains trichlorosilane. The silicon is deposited onto the carrier body 12 due to thermal decomposition of the trichlorosilane. However, it is to be appreciated that the manufacturing apparatus 10 can be used to deposit materials other than silicon on the carrier body 12. Additionally, it is to be appreciated that the material to be deposited may be a composition, which comprises more than one material.

Generally, it is beneficial to prevent impurities from contaminating the material. An impurity or impurities, as the terms are generally used herein, are defined as an element or a compound the presence of which is undesirable in the material deposited. For example, when the material to be deposited is silicon, the impurities of concern typically include aluminum, arsenic, boron, phosphorous, iron, nickel, copper, chromium, and combinations thereof. Generally, limiting impurities present in the material deposited on the carrier body 12 results in a high purity of the material. High purity, as the term is used herein, means that the material has an impurity content of less than or equal to 1 parts per million atomic. However, it is to be appreciated that when the material to be deposited is silicon, there are additional distinctions between deposited silicons, which can be made based on sequentially lower impurity contents. While the above threshold for characterizing the material as having a high purity provides an upper limit for the impurity content, deposited silicons can still be characterized as high purity with substantially lower impurity content than the threshold set forth above.

With reference to Figure 1, the manufacturing apparatus 10 also comprises an inlet 42 defined by the housing 16 for introducing the deposition composition into the reaction chamber 18. It is to be appreciated that the inlet 42 may be defined by the base plate 14. Typically, an inlet pipe 44 is connected to the inlet 42 for delivering the deposition composition in a gaseous state to the reaction chamber 18. The manufacturing apparatus 10 may also comprise an outlet 46 defined by the housing 16 for allowing the deposition composition or a reaction byproduct thereof to be removed from the reaction chamber 18.

Generally, the mechanical interaction between the flange 26 and the base plate 14 is insufficient to prevent the deposition composition from escaping the reaction chamber 18. Additionally, the mechanical interaction between the flange 26 and the base plate 14 is typically insufficient to prevent impurities external to the reaction chamber 18, such as impurities in the ambient atmosphere outside the reaction chamber 18, from entering the reaction chamber 18. Therefore, the manufacturing apparatus 10 further comprises at least one gasket 48 disposed between the base plate 14 and the housing 16 for sealing between the housing 16 and the base plate 14.

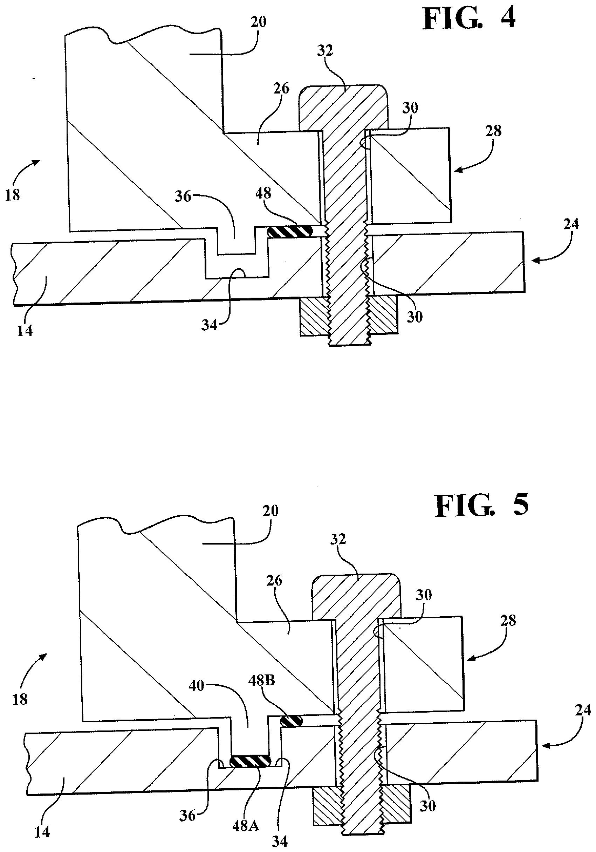

With reference to Figures 2-5, the gasket 48 seals between the housing 16 and the base plate 14. Generally, the gasket 48 is compressed between the flange 26 and the base plate 14 for sealing the reaction chamber 18 to prevent the deposition composition from escaping the reaction chamber 18. For example, when the deposition composition comprises trichlorosilane, the deposition composition is a gas and the gasket 48 prevents the trichlorosilane from escaping the reaction chamber 18. Additionally, the gasket 48 prevents impurities external to the reaction chamber 18 from entering the reaction chamber 18 during operation of the manufacturing apparatus 10. The gasket 48 may be disposed within the groove 34 of the base plate 14 with the finger 36 contacting the gasket 48 to compress the gasket 48 for sealing between the housing 16 and the base plate 14, as shown in Figure 2. Additionally, as shown in Figure 3, the gasket 48 may be disposed on the base plate 14 adjacent the groove 34 within the reaction chamber 18 with the flange 26 contacting the gasket 48 to compress the gasket 48 for sealing between the housing 16 and the base plate 14. Furthermore, as show in Figure 4, the gasket 48 may be disposed on the base plate 14 adjacent the groove 34 outside of the reaction chamber 18 with the flange 26 contacting the gasket 48 to compress the gasket 48 for sealing between the housing 16 and the base plate 14.

With reference to Figure 5, the at least one gasket 48 may be further defined as a first gasket 48A and a second gasket 48B. Typically, the first gasket 48A is disposed within the groove 34 and the second gasket 48B is disposed on the base plate 14 adjacent the groove 34. The second gasket 48B may be outside the reaction chamber 18 or within the reaction chamber 18. The finger 36 contacts the first gasket 48A to compress the first gasket 48A for sealing between the housing 16 and the base plate 14. The flange 26 contacts the second gasket 48B to compress the second gasket 48B to further seal between the housing 16 and the base plate 14.

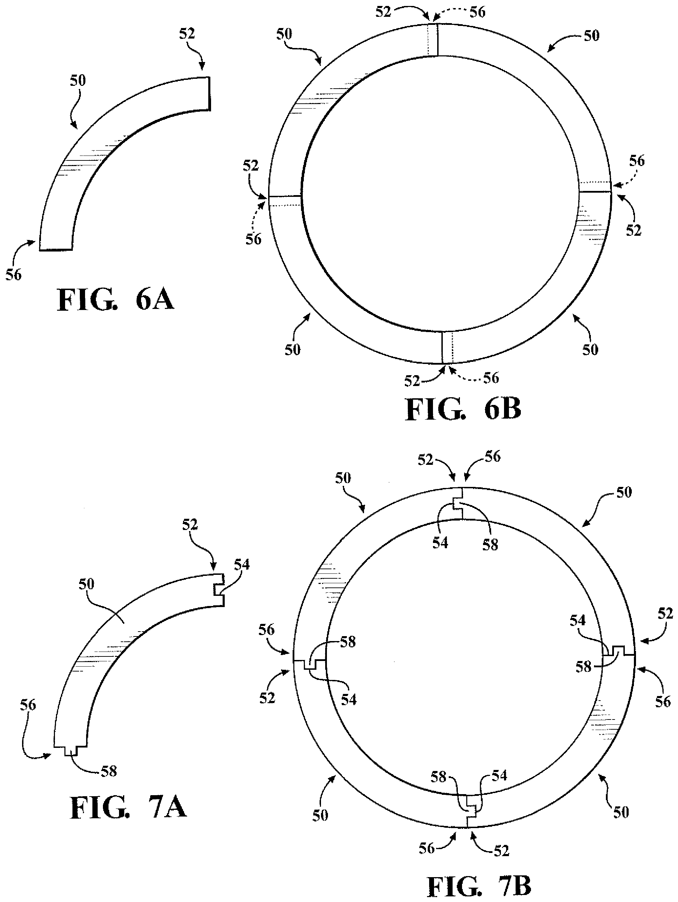

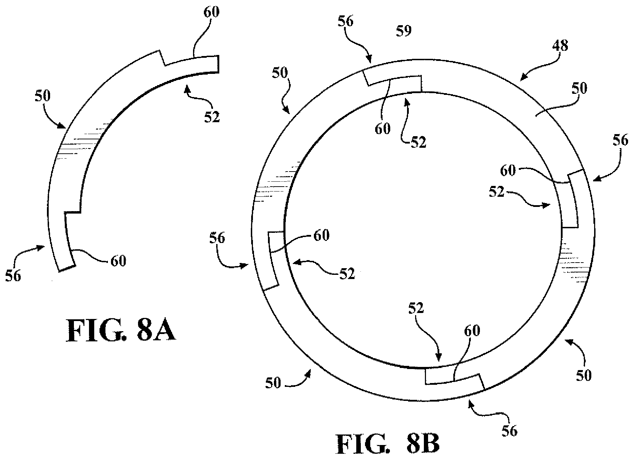

With reference to Figures 6A-8B, the gasket 48 may comprise a plurality of segments 50 with adjacent segments 50 contacting each other in series to form the gasket 48. Generally, the segments 50 have a first end 52 and a second end 54 spaced from the first end 52. As shown in Figures 6A and 6B, the segments 50 may overlap one another for forming the gasket 48. For example, the first end 52 of one of the segments 50 may be stacked on top of the second end 54 of another one of the segments 50. Alternatively, as shown in Figures 7A and 7B, the first end 52 of each of the segments 50 may define a recess 54 and the second end 56 may have a leg 58. In such an embodiment, the leg 58 of one of the segments 50 engaging the recess 54 of another one of the segments 50 for interlocking the segments 50 to form the gasket 48. As another alternative shown in Figures 8A and 8B, the first end 52 and the second end 56 of the segments 50 may define a notch 60 on opposing sides of each of the segments 50 with the first end 52 of one of the segments 50 engaging the notch 60 of another one of the segments 50 for interlocking the segments 50 to form the gasket 48. The gasket 48 comprises the plurality of segments 50 for allowing the gasket 48 to be formed of various diameters and thicknesses. For example, additional segments 50 are interlocked to increase the diameter of the gasket 48. Alternatively, fewer segments 50 are interlocked to decrease the diameter of the gaskets 48.

During operation of the manufacturing apparatus 10, pressure within the reaction chamber 18 may increase to an operating pressure. Although pressure within the reaction chamber 18 may reach the operating pressure, the gasket 48 is still capable of sealing between the housing 16 and the base plate 14. Typically, the operating pressure is less than of from about 15, more typically of from about 2 to about 8, and even more typically of from about 3 to about 7 atmospheres. The engagement of the finger 36 with the groove 34 prevents a side blowout of the reactor chamber 18. Said differently, the engagement of the finger 36 and the groove 34 prevents the gasket 48 from rupturing as pressure within the reaction chamber 18 increases. Furthermore, the engagement of the finger 36 with the groove 34 allows the gasket 48 to be thinner.

The gasket 48 comprises a flexible graphite material. Generally, the flexible graphite material is used to allow the gasket 48 to adequately seal the reaction chamber 18 while minimizing or even preventing the introduction of impurities into the reaction chamber 18 that may contaminate the material deposited on the carrier body 12. Said differently, the flexible graphite material allows the gasket 48 to adjust to surfaces of the housing 16 and the base plate 14 thereby sealing the reaction chamber 18. Additionally, the flexible graphite material of the gasket 48 has a hardness that allows the material to be compressed between the housing 16 and the base plate 14. Said differently, the flexible graphite material of the gasket 48 is soft enough to allow the gasket 48 to compress between the housing 16 and the base plate 14.

Generally, the gasket 48 is in atmospheric communication with the reaction chamber 18. As such, the gasket 48 is heated as a result of the operating temperature of the reaction chamber 18, which, over time, can damage the gasket 48. Additionally, the gasket 48 maintains the seal of the reaction chamber 18 even though the gasket 48 is exposed to the operating pressure within the reaction chamber 18. Exposing the gasket 48 to the operating temperature and operating pressure can result in creep relaxation, which can prevent the gasket 48 from sealing the reaction chamber 18. However, the gasket 48 made from the flexible graphite material can maintain a compressive strength required to seal the reaction chamber 18 for a longer period of time as compared to other prior art gaskets made from other materials, such as Tef^{l}on®, while being exposed to the operating temperature and operating pressure within the reaction chamber 18. Generally, the flexible graphite material of the gasket 48 has a creep relaxation of less than 3% to ensure the gasket 48 maintains the seal of the reaction chamber 18. Typically, the creep relaxation can be tested using Method BSI-F125.

The gasket 48 is also in atmospheric communication with the carrier body 12 within the reaction chamber 18 and is therefore in atmospheric communication with the material as it is deposited on the carrier body 12. Therefore, care must be taken to ensure that the gasket 48 does not contribute impurities into the reaction chamber 18. As such, the flexible graphite material of the gasket 48 has a thermal stability suitable to prevent decomposition, which can result in the introduction of impurities into the reaction chamber 18, when exposed to the operating temperature. Additionally, may contribute impurities into the reaction chamber 18 through decomposition of the gasket 48, which can occur as a result of being exposed to the operating temperatures and the deposition gas. Said differently, the gasket 48 does not decompose when subjected to the operating temperature. Additionally, the flexible graphite material of the gasket 48 has a chemical resistance suitable to prevent decomposition of the gasket 48, which can result in the introduction of impurities into the reaction chamber 18, when exposed to the deposition gas, such as chlorine containing gases like chlorosilane.

The thermal stability and chemical resistance of the flexible graphite material of the gasket 48 results in the flexible graphite material minimally contributing impurities, if at all, into the reaction chamber 18 although the flexible graphite material is in atmospheric communication with the carrier body 12. Said differently, because the flexible graphite material of the gasket 48 can resist decomposition when exposed to the deposition gas and the operating temperature of the reaction chamber 18, the introduction of impurities, which may be present in the gasket 48, is limited or prevented all together.

Typically, when the material deposited on the carrier body 12 is to be high purity, the flexible graphite material of the gasket 48 contributes an amount of impurities to the material deposited on the carrier body 12 that is less than 1 parts per million atomic. However, even when the material deposited on the carrier body 12 is not high purity, the flexible graphite material of the gasket 48 contributes less impurities than known gaskets in the prior art, such as gaskets made from a Teflon® impregnated material. The limitation or prevention of impurities within the gasket 48 contaminating the material deposited on the carrier body 12 allows the material deposited on the carrier body 12, especially polycrystalline silicon, to meet and/or exceed the high purity threshold described above. Additionally, the limitation or prevention of impurities from the gasket 48 contaminating the material deposited on the carrier body 12 may be accomplished despite the fact that the manufacturing apparatus 10 is not equipped with cooling devices for reducing the heating of the gasket 48. However, it is to be appreciated that cooling devices, such as a water-cooling jacket may be used to further enhance the contamination limiting effect of the flexible graphite material.

Typically, the flexible graphite material of the gasket 48 comprises at least 99.75, more typically at least 99.88, and even more typically at least 99.95 parts of graphite based on 100 parts by weight of the flexible graphite material. Said differently, the flexible graphite material comprises at least 99.92 percent graphite. Said yet another way, typically, the flexible graphite material has an impurity content of less than 2,500, more typically less than 1,200, and even more typically less than 600 parts per million atomic. The flexible graphite material may also be referred to as nuclear grade graphite because of the high percentage of graphite relative to impurities makes the flexible graphite material suitable for use in nuclear reactors. Because the impurity content of the flexible graphite material is low, the flexible graphite material contributes less than about 10, more typically less than about 5, and even more typically less than about 1 parts per million atomic of impurities to the material deposited on the carrier body 12.

Despite the small percentage of impurities present in the flexible graphite material, the impurity content of boron and phosphorous within the flexible graphite material is further minimized to prevent contamination of the material deposited on the carrier body 12. This is particularly beneficial when the material deposited is silicon, because boron and phosphorous are two impurities which can be of concern in the production of polycrystalline silicon. Typically, the flexible graphite material contains an amount of phosphorous that is less than 10.0, more typically less than 6.0 and even more typically less than 1.0 parts per million atomic. It is to be appreciated that the flexible graphite material may be purified with chlorine to remove phosphorous from the flexible graphite material. Said differently, the flexible graphite material may be exposed to chlorine gas to remove phosphorous from the flexible graphite material. Additionally, the flexible graphite material typically contains an amount of boron that is less than 1.0, more typically less than 0.8 and even more typically less than 0.5 parts per million atomic. Furthermore, the flexible graphite material of the gasket 48 may be substantially free of boron and/or phosphorous.

As introduced above, the flexible graphite material allows the gasket 48 to adequately seal the reaction chamber 18. Additionally, the flexible graphite material does not release impurities into the reaction chamber 18 when the gasket 48 is exposed to the operating temperatures of the reaction chamber 18. Therefore, the gasket 48 can be used within the manufacturing apparatus 10 to deposit the material having the high purity. For example, when the material deposited is silicon for producing polycrystalline silicon, the polycrystalline silicon is produced with the high purity because possible contamination by the gasket 48 has been limited or even eliminated because the gasket 48 comprises the flexible graphite material.

Obviously, many modifications and variations of the present invention are possible in light of the above teachings. The foregoing invention has been described in accordance with the relevant legal standards; thus, the description is exemplary rather than limiting in nature. Variations and modifications to the disclosed embodiment may become apparent to those skilled in the art and do come within the scope of the invention. Accordingly, the scope of legal protection afforded this invention may only be determined by studying the following claims.

## Claims

1. A manufacturing apparatus for depositing a material on a carrier body, said manufacturing apparatus comprising:
a base plate;
a housing having a flange for coupling with said base plate to define a reaction chamber;
an inlet defined by said housing for introducing a deposition composition, which comprises the material or a precursor thereof into said reaction chamber; and at least one gasket disposed between said base plate and said housing for sealing between said housing and said base plate for preventing the deposition composition from escaping said reaction chamber;
wherein said gasket comprises a flexible graphite material for preventing said gasket from contaminating the material within said reaction chamber.

2. A manufacturing apparatus as set forth in claim 1 wherein said flexible graphite material contributes less than 10 parts per million atomic of impurities to the material deposited on the carrier body.

3. A manufacturing apparatus as set forth in any preceding claim wherein said flexible graphite material consists essentially of graphite.

4. A manufacturing apparatus as set forth in any preceding claim wherein said base plate defines a groove and wherein a finger extends from said flange of said housing for engaging said groove of said base plate.

5. A manufacturing apparatus as set forth in any preceding claim wherein said gasket comprises a plurality of segments with each of said segments contacting each other to form said gasket.

6. The manufacturing apparatus as set forth in any preceding claim, wherein the manufacturing apparatus is a Siemens type chemical vapor deposition reactor for depositing silicon on a silicon slim rod for producing high purity polycrystalline silicon,.

7. The Siemens type chemical vapor deposition reactor as set forth in claim 6 wherein said flexible graphite material contributes less than 10 parts per million atomic of impurities to the silicon deposited on the silicon slim rod.

8. The Siemens type chemical vapor deposition reactor as set forth in claims 6 or 7 wherein said flexible graphite material consists essentially of graphite.

9. The Siemens type chemical vapor deposition reactor as set forth in any of claims 6-8 wherein said base plate defines a groove and wherein a finger extends from said flange of said housing for engaging said groove of said base plate.

10. The Siemens type chemical vapor deposition reactor as set forth in any of claims 6-9 wherein said gasket comprises a plurality of segments with each of said segments contacting each other to form said gasket.

## Patentansprüche

1. Ein Herstellungsgerät zum Abscheiden eines Materials auf einem Trägerkörper, wobei das Herstellungsgerät Folgendes beinhaltet:
eine Basisplatte;
ein Gehäuse mit einem Flansch zum Koppeln an die Basisplatte, um eine Reaktionskammer zu definieren;
einen Einlass, der durch das Gehäuse definiert ist, um eine
Abscheidungszusammensetzung, die das Material oder einen Vorläufer davon beinhaltet, in die Reaktionskammer einzuführen; und mindestens eine Dichtung, die zwischen der Basisplatte und dem Gehäuse angeordnet ist, um zwischen dem Gehäuse und der Basisplatte abzudichten, um zu verhindern, dass die Abscheidungszusammensetzung aus der Reaktionskammer entweicht;
wobei die Dichtung ein flexibles Graphitmaterial beinhaltet, um zu verhindern, dass die Dichtung das Material in der Reaktionskammer verunreinigt.

2. Herstellungsgerät gemäß Anspruch 1, wobei das flexible Graphitmaterial weniger als 10 atomare Teile pro Million an Verunreinigungen zu dem auf dem Trägerkörper abgeschiedenen Material beiträgt.

3. Herstellungsgerät gemäß einem der vorhergehenden Ansprüche, wobei das flexible Graphitmaterial im Wesentlichen aus Graphit besteht.

4. Herstellungsgerät gemäß einem der vorhergehenden Ansprüche, wobei die Basisplatte eine Nut definiert und wobei sich ein Finger von dem Flansch des Gehäuses zum Eingreifen in die Nut der Basisplatte erstreckt.

5. Herstellungsgerät gemäß einem der vorhergehenden Ansprüche, wobei die Dichtung eine Vielzahl von Segmenten beinhaltet, wobei jedes der Segmente jeweils das andere berührt, um die Dichtung zu bilden.

6. Herstellungsgerät gemäß einem der vorhergehenden Ansprüche, wobei es sich bei dem Herstellungsgerät um einen chemischen Gasphasenabscheidungsreaktor vom Typ Siemens zum Abscheiden von Silizium auf einem Slim-Siliziumstab zur Herstellung von hochreinem polykristallinem Silizium handelt.

7. Chemischer Gasphasenabscheidungsreaktor vom Typ Siemens gemäß Anspruch 6, wobei das flexible Graphitmaterial weniger als 10 atomare Teile pro Million an Verunreinigungen zu dem auf dem Slim-Siliziumstab abgeschiedenen Silizium beiträgt.

8. Chemischer Gasphasenabscheidungsreaktor vom Typ Siemens gemäß Anspruch 6 oder 7, wobei das flexible Graphitmaterial im Wesentlichen aus Graphit besteht.

9. Chemischer Gasphasenabscheidungsreaktor vom Typ Siemens gemäß einem der Ansprüche 6-8, wobei die Basisplatte eine Nut definiert und wobei sich ein Finger von dem Flansch des Gehäuses zum Eingreifen in die Nut der Basisplatte erstreckt.

10. Chemischer Gasphasenabscheidungsreaktor vom Typ Siemens gemäß einem der Ansprüche 6-9, wobei die Dichtung eine Vielzahl von Segmenten aufweist, wobei jedes der Segmente das andere berührt, um die Dichtung zu bilden.

## Revendications

1. Un appareil de fabrication pour déposer un matériau sur un corps de support, ledit appareil de fabrication comprenant :
une plaque de base ;
un logement ayant une bride pour un couplage avec ladite plaque de base afin de définir une chambre de réaction ;
une entrée définie par ledit logement pour introduire une composition de dépôt, qui comprend le matériau ou un précurseur de celui-ci dans ladite chambre de réaction ; et
au moins un joint d'étanchéité disposé entre ladite plaque de base et ledit logement pour assurer l'étanchéité entre ledit logement et ladite plaque de base afin d'empêcher la composition de dépôt de s'échapper de ladite chambre de réaction ;
dans lequel ledit joint d'étanchéité comprend un matériau graphite flexible pour empêcher ledit joint d'étanchéité de contaminer le matériau à l'intérieur de ladite chambre de réaction.

2. Un appareil de fabrication tel qu'énoncé dans la revendication 1 dans lequel ledit matériau graphite flexible contribue moins de 10 parties atomiques par million d'impuretés au matériau déposé sur le corps de support.

3. Un appareil de fabrication tel qu'énoncé dans n'importe quelle revendication précédente dans lequel ledit matériau graphite flexible consiste essentiellement en du graphite.

4. Un appareil de fabrication tel qu'énoncé dans n'importe quelle revendication précédente dans lequel ladite plaque de base définit une rainure et dans lequel un doigt s'étend à partir de ladite bride dudit logement pour se mettre en prise avec ladite rainure de ladite plaque de base.

5. Un appareil de fabrication tel qu'énoncé dans n'importe quelle revendication précédente dans lequel ledit joint d'étanchéité comprend une pluralité de segments, chacun desdits segments étant en contact l'un avec l'autre pour former ledit joint d'étanchéité.

6. L'appareil de fabrication tel qu'énoncé dans n'importe quelle revendication précédente, dans lequel l'appareil de fabrication est un réacteur de dépôt chimique en phase vapeur de type Siemens pour déposer du silicium sur un mince barreau de silicium afin de produire du silicium polycristallin de haute pureté.

7. Le réacteur de dépôt chimique en phase vapeur de type Siemens tel qu'énoncé dans la revendication 6 dans lequel ledit matériau graphite flexible contribue moins de 10 parties atomiques par million d'impuretés au silicium déposé sur le mince barreau de silicium.

8. Le réacteur de dépôt chimique en phase vapeur de type Siemens tel qu'énoncé dans les revendications 6 ou 7 dans lequel ledit matériau graphite flexible consiste essentiellement en du graphite.

9. Le réacteur de dépôt chimique en phase vapeur de type Siemens tel qu'énoncé dans n'importe lesquelles des revendications 6 à 8 dans lequel ladite plaque de base définit une rainure et dans lequel un doigt s'étend à partir de ladite bride dudit logement pour se mettre en prise avec ladite rainure de ladite plaque de base.

10. Le réacteur de dépôt chimique en phase vapeur de type Siemens tel qu'énoncé dans n'importe lesquelles des revendications 6 à 9 dans lequel ledit joint d'étanchéité comprend une pluralité de segments, chacun desdits segments étant en contact l'un avec l'autre pour former ledit joint d'étanchéité.
